# EUROPÄISCHE PATENTSCHRIFT

(11) **EP 2 048 782 B1**
(45) Veröffentlichungstag und Bekanntmachung des Hinweises auf die Patenterteilung: **12.01.2011**
(21) Anmeldenummer: 08164703.4
(22) Anmeldetag: 19.09.2008
(51) Int. Cl.: H03K 17/96

(54) **Betätigbare Schalteinrichtung für ein Kraftfahrzeug**
Switching device for a motor vehicle that can be operated
Dispositif de commutation actionnable pour un véhicule automobile

(30) Priorität: 08.10.2007 DE 102007000832; 22.10.2007 DE 102007000552
(43) Veröffentlichungstag der Anmeldung: 15.04.2009
(73) Patentinhaber: Huf Hülsbeck & Fürst GmbH & Co. KG, 42551 Velbert (DE)
(72) Erfinder: Peschl, Andreas, 45249, Velbert (DE); Witte, Martin, 48683, Ahaus (DE)
(74) Vertreter: Zenz

(56) Entgegenhaltungen:
- EP-A1- 0 210 386
- EP-A1- 0 933 873
- EP-A1- 1 780 159
- EP-A2- 1 473 782

## Beschreibung

Die Erfindung betrifft eine betätigbare Schalteinrichtung für ein Kraftfahrzeug. Insbesondere betrifft die Erfindung eine elektrische Schalteinrichtung, welche als Signalgeber für eine erfolgte Betätigung durch einen Benutzer dient.

Die Schalteinrichtung weist zum Erfassen der Betätigung ein Piezo-Element auf, welches für den Abgriff einer Piezo-Spannung kontaktiert ist. Piezo-Elemente enthalten regelmäßig einen oder mehrere Piezokristalle. Derartige Kristalle erzeugen bei Deformation an ihren Oberflächen elektrische Ladungen.

Piezo-Elemente werden häufig als Schallgeber oder Drucksensor oder Betätigungssensor verwendet. Für die Vorbereitung einer derartigen Verwendung wird ein Piezo-Element, welches häufig eine runde oder eckige flache Tablettenform aufweist, beidseitig an den aufgebrachten Elektroden kontaktiert. Hierbei wird beispielsweise einseitig eine Metallplatte angebracht und auf der abgewandten Seite des Piezo-Elements eine Kontaktierung angelötet.

Bei der Verwendung eines derartigen Piezo-Elements in einer Schalteinrichtung für ein Kraftfahrzeug kann ein Bediener einen Druck auf das Piezo-Element ausüben, was zu einer Verformung des Piezo-Elements führt. Die Durchbiegung bzw. Verformung des Piezo-Elements resultiert in einer abgreifbaren Spannung oder Ladung zwischen den Elektroden des Piezo-Elements. Das sich beim Durchbiegen des Piezo-Elements an den Anschlüssen ergebende Spannungssignal oder Ladungssignal kann durch eine Auswerteelektronik in ein Schaltsignal umgewandelt werden. Ein Beispiel für ein solches Piezo-Element liefert die Druckshrift EP 1 473 782 A2.

Ein Problem der bekannten Piezo-Elemente ist die Robustheit und Verlässlichkeit der Kontaktierung an den aufgebrachten Elektroden, sowie der Aufwand zur Herstellung eines Schaltelements. Beispielsweise können die auf das Piezo-Element aufgelöteten Drähte leicht unter mechanischer Belastung abreißen.

Der Erfindung liegt die Aufgabe zugrunde, eine verbesserte Schalteinrichtung für ein Kraftfahrzeug bereitzustellen, welche mechanisch haltbar und kostengünstig herzustellen ist.

Die Aufgabe wird erfindungsgemäß gelöst durch eine Schalteinrichtung gemäß Patentanspruch 1 sowie ein Verfahren zum Herstellen einer Schalteinrichtung mit den Merkmalen des Patentanspruchs 7.

Erfindungsgemäß ist bei der Schalteinrichtung das Piezo-Element zur einseitigen Kontaktierung ausgebildet. Das Piezo-Element weist auf einer ersten flächigen Seite wenigstens zwei getrennte, d.h. elektrisch nicht leitend verbundene, Elektroden auf.

In einer alternativen Ausführungsform sind die Kontaktbereiche der Kontaktierung jeweils einer flächigen Seite des Piezo-Elements zugeordnet. Ein erster Kontaktbereich kontaktiert eine erste flächige Seite und ein zweiter Kontaktbereich kontaktiert eine zweite flächige Seite, welche der ersten flächigen Seite abgewandt ist. Das Piezo-Element bietet demnach auf einer Seite Kontaktierungsmöglichkeiten für beide Seiten des Piezo-Elementes. Um eine ordnungsgemäße Kontaktierung der abgewandten Seite des Piezo-Elements zu ermöglichen, ist der zweite Kontaktbereich von der ersten zur zweiten Seite um das Piezo-Element herum geführt, wobei er sich entsprechend über einen Randbereich des Piezo-Elements erstreckt. Der erste Kontaktbereich erstreckt sich hingegen nicht über den Rand bis zur abgewandten Rückseite des Piezo-Elements.

Das Piezo-Element ist mit der Seite, welche die getrennten Kontaktbereiche aufweist, auf eine Leiterstruktur aufgeklebt, die auf einem Träger angeordnet ist. Die Leiterstruktur kontaktiert jeweils mit getrennten Leitern den ersten Kontaktbereich bzw. den zweiten Kontaktbereich, also die beiden von einander abgewandten Seiten des Piezo-Elements.

Erfindungsgemäß liegt das Piezo-Element demnach mit der Seite, welche die getrennten Kontaktbereiche aufweist, auf einem Träger mit Leitern auf, während die vom Träger wegweisende (abgewandte) Seite über die dem Träger zugewandte Seite kontaktiert ist.

Das Piezo-Element ist auf die Leiterstruktur aufgeklebt, was eine aufwändige Herstellung von Lötverbindungen und die damit verbundene Möglichkeit einer Beschädigung überflüssig macht. Beim Aufkleben ist lediglich darauf zu achten, dass die Kontaktbereiche ausschließlich mit den Ihnen zugeordneten Leitern in Verbindung gelangt.

Die dem Träger abgewandte Seite liegt ohne störende Kontaktierungsbereiche (wie z.B. Lötstellen) frei und kann, je nach Verwendungszweck, zur unmittelbaren oder übertragenen Betätigung durch einen Benutzer genutzt werden. Beispielsweise kann die Schalteinrichtung in einem Türgriff angeordnet werden. Eine durch einen Benutzerzugriff hervorgerufene Krafteinleitung, entweder unmittelbar oder zum Beispiel durch eine Hebelanordnung auf das Piezo-Element übertragen, verändert die Piezo-Spannung oder die Piezo-Ladung, die an den Leitern der Leiteranordnung abgegriffen wird. Über die Auswertung der Spannung oder Ladung ist eine Betätigung registrierbar.

Entsprechend weist die erfindungsgemäße Schalteinrichtung Vorteile hinsichtlich einer flexibleren Einsetzbarkeit auf, da auf einer für die Betätigung vorgesehenen Seite der Schalteinrichtung keine störenden Kontaktierungsbereiche oder Lötverbindungen vorhanden sind. Andererseits ist die Herstellung der Schalteinrichtung besonders einfach und kostengünstig, da keine Lötverbindungen herzustellen sind, sondern das Piezo-Element lediglich auf einem geeigneten Träger mit einer Leiterstruktur aufgeklebt wird.

In einer bevorzugten Ausführungsform der Erfindung sind der Träger und die Leiterstruktur als Leiterplatte mit Leiterbahnen ausgebildet.

Wird das Piezo-Element mit seinen einseitigen Kontaktierungen auf die Leiterplatte bzw. -platine aufgeklebt, so ist eine flächige und mechanisch stabile Verbindung geschaffen und Höhenunterschiede zwischen den Leiterbahnen auf der Leiterplatte und der Platine selbst werden durch den Klebstoff ausgeglichen, so dass das Piezo-Element mit seiner im wesentlichen gesamten Auflagefläche befestigt werden kann. Als Material für die Leiterplatten kommen beliebige bekannte Materialien, wie z.B. harzgetränkte Glasfasermatten, jedoch auch Spezialmaterialien wie Teflon oder Keramik oder Polyesterfolie in Frage. Die Leiterstruktur ist auf den Träger in der üblichen Weise zur Herstellung bedruckter Schaltungen aufgebracht.

Vorzugsweise hat die Leiterplatte eine Dicke von weniger als 1 mm, besonders vorteilhaft ist eine Dicke von weniger als 0.4 mm.

Die dünne Gestaltung der Leiterplatte ermöglicht eine Verformung bei mechanischer Belastung, so dass die Leiterplatte einer Belastung des Piezo-Elements folgen kann und so eine entsprechende Verformung mitvollzieht.

Das Piezo-Element wird zusammen mit der darunter liegenden Leiterplatte und den darauf befindlichen Leitern verformt, wobei die mechanisch stabile Verbindung zwischen Piezo-Element und Träger aufrecht erhalten wird.

In einer weiteren Ausführungsform der Erfindung ist auf der dem Piezo-Element abgewandten Seite des Trägers eine Halteeinrichtung ausgebildet, die den Träger hält und ein Durchbiegen des Trägers bei mechanischer Belastung des Piezo-Elements erlaubt.

Das Piezo-Element ist bei dieser Gestaltung auf dem Träger aufgeklebt und der Träger ist in Bereichen, die in der Ebene des Trägers zu dem Piezo-Element versetzt sind, an der Halteeinrichtung gehalten. Auf diese Weise ist der Träger zusammen mit dem aufgeklebten Piezo-Element derart in der Halteeinrichtung befestigt, dass er der mechanischen Belastung nachgeben und eine Verformung des Piezo-Elements mitvollziehen kann und anschließend, bei Wegfall der Betätigungsbelastung, in der Halterung in die Ausgangsstellung zurückfedert.

Beispielsweise kann der Träger seitlich in Schienen oder Nuten eingeschoben sein, so dass er unmittelbar an der Halteeinrichtung fixiert ist, zwischen den Halteeinrichtungen jedoch, im Bereich des aufgebrachten Piezo-Elements, biegefähig gehalten ist.

In einer bevorzugten Weiterbildung der Erfindung weist die Halteeinrichtung einen Anschlag auf, welche die maximale Durchbiegung des Trägers begrenzt.

Wird bei der mechanischen Betätigung der Schalteinrichtung eine Kraft aufgebracht, die eine zum Erzeugen eines detektierbaren Signals erforderliche Stärke übersteigt, kann mit Hilfe des Anschlags die Durchbiegung des Trägers und Verformung des Piezo-Elements begrenzt werden. Der entsprechend ausgebildete Anschlag dient der Vorgabe einer Endlage des Trägers und des Piezo-Elements und verhindert eine übermäßige Durchbiegung und Beschädigung der Schalteinrichtung.

Es ist besonders vorteilhaft, wenn das Piezo-Element mit einem elektrisch isolierenden Klebstoff unter Druck derart auf die Leiterstruktur und den Träger aufgeklebt ist, dass eine Leitverbindung nur in solchen Bereichen zwischen den Kontaktflächen des Piezo-Elements und den Leiterstrukturen hergestellt wird, die in unmittelbarem Kontakt stehen.

Da die mechanische Verbindung zwischen Piezo-Element und Träger durch einen elektrisch isolierenden Klebstoff gebildet ist, ist die Montage und Befestigung besonders einfach. Es besteht nämlich keinerlei Gefahr für die unbeabsichtigte Herstellung einer elektrisch leitenden Verbindung. Wird die Fixierung mit entsprechendem Druck ausgeführt, so wird aufgrund der naturgemäß vorhandenen Rauhigkeit im Oberflächenbereich sowohl des Trägers und der Leiterstruktur als auch des Piezo-Elements, ein Kontakt an solchen Stellen hergestellt, wo der Klebstoff vollständig oder weitestgehend verdrängt ist. Andererseits wird flächig eine mechanisch stabile Verbindung hergestellt weil ausreichende Zwischenräume in anderen Bereichen verbleiben, die der Klebstoff füllt. Da das Piezo-Element für den Nachweis bzw. die Erfassung einer mechanischen Kraft eine Spannung oder Ladung hervorruft, jedoch bei dem Nachweis (nahezu) kein Stromfluss erforderlich ist, sind derartige Kontaktbereiche vollkommen ausreichend, um die entsprechenden Spannungen oder Ladungen an die Leiter zu koppelt und dort zu erfassen.

Unter welchem Druck das Piezo-Element auf den Träger aufzubringen ist, hängt von dem verwendeten Klebstoff bzw. seiner Viskosität und seines Ausdehnungsverhaltens ab. Es kann jedoch dazu auf entsprechende Erfahrungen bei der Aufbringung von Metallplättchen auf Piezo-Kristall zurückgegriffen werden, wie sie im Stand der Technik bekannt sind.

Die Erfindung wird nun anhand der beiliegenden Zeichnungen näher erläutert.

Figur 1A zeigt ein Piezo-Element zum Einsatz in der erfindungsgemäßen Schalteinrichtung in perspektivischer Ansicht.

Figur 1B zeigt das Piezo-Element aus Figur 1A in einer um 180° gedrehten Ansicht.

Figur 2 zeigt eine schematische Seitenansicht einer erfindungsgemäßen Schalteinrichtung.

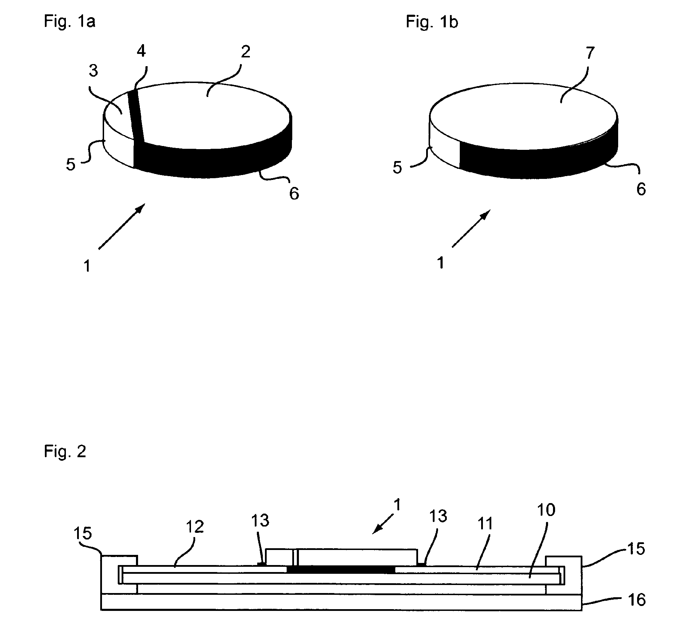

Das Piezo-Element 1 in Figur 1A ist tablettenförmig ausgebildet und weist eine kreisförmige Oberseite und eine kreisförmige Unterseite auf. Ein zylindrischer Seitenbereich erstreckt sich zwischen Oberseite und Unterseite. Die in Figur 1A oben liegend dargestellte Seite, ist die in erfindungsgemäßer Verwendung (bei Anbringung auf dem Träger) des Piezo-Elements unten zu liegen kommende Seite und wird im Folgenden als Unterseite bezeichnet. Diese Seite weist eine Kontaktfläche 2 sowie eine Kontaktfläche 3 auf. Die Kontaktfläche 2 ist aus einem leitfähigen Material gebildet und deckt ein Großteil der Fläche der Unterseite des Piezo-Elements ab. Die Kontaktfläche 3 deckt einen geringeren Teil der Kreisfläche der Unterseite des Piezo-Elements ab. Die Kontaktflächen 2 und 3 sind durch einen nichtleitenden Bereich 4 getrennt.

Von der Kontaktfläche 3 erstreckt sich über den zylindrischen Randbereich 5 eine durchgehende Kontaktierung zu der Oberseite (in Fig. 1a verdeckt) des Piezo-Elements. Der Kontaktbereich 3 und der leitende Randbereich 5 sind demnach elektrisch leitend verbunden. Mit dem elektrisch isolierenden Bereich 4 ist der elektrische isolierende Randbereich 6 durchgehend verbunden. Der Randbereich 6 läuft von den zwei Enden des Streifens 4 am Rand der Tablette um die Tablette um, so dass keine leitende Verbindung zwischen den Kontaktbereichen 2 einerseits und 3 und 5 andererseits gebildet ist.

Figur 1B zeigt das Piezo-Element aus Figur 1A, wobei in Figur 1B die Oberseite des Piezo-Elements oben liegt und die in Figur 1A detailliert dargestellte Unterseite verdeckt ist. Einen sich über die gesamte Oberseite des Piezo-Elements erstreckende Kontaktfläche 7 ist mit einem leitfähigen Material überzogen und mit dem leitfähigen Seitenbereich 5 leitend verbunden. Der in Figur 1B verdeckte Kontaktbereich 3 an der Unterseite des Piezo-Elements ist demnach über die leitende Randverbindung 5 mit der leitenden Kontaktfläche 7 elektrisch gekoppelt. Der isolierende Randbereich 6 verhindert eine elektrische leitende Verbindung des Bereichs 7 mit dem Kontaktbereich 2 oder 5.

Mit dem in Figur 1A und 1B dargestellten Piezo-Element ist demnach eine von der Unterseite des Piezo-Elements ausgehende Kontaktierung beider Seiten des Piezo-Elements möglich, wobei die Fläche 2 eine Kontaktierung der Unterseite bereitstellt und die Fläche 3 eine Kontaktierung der Oberfläche bereitstellt.

In Figur 2 ist eine schematische beispielhafte Seitenansicht einer Schalteinrichtung dargestellt, welche das Piezo-Element, wie es in den Figuren 1A und 1B dargestellt ist, verwendet. Das Piezo-Element 1 ist mit seiner Unterseite auf einem Träger 10 platziert, auf dem eine Leiterstruktur 11, 12 angeordnet ist. An der Unterseite des Piezo-Elements 1 ist ein elektrisch isolierender Klebstoff 13 aufgebracht und das Piezo-Element ist unter Druck auf die Leiteranordnung 11, 12 und den Träger 10 aufgepresst worden, so dass der Klebstoff in solchen Bereichen, in denen der Körper des Piezo-Elements aufgrund von Oberflächenrauhigkeit mit der Leiterstruktur 11, 12 in direkten Kontakt kommt, verdrängt wurde. Durch das Aufpressen wird also eine elektrische leitende Verbindung zwischen den Kontaktbereichen 3 bzw. 2 und der Leiteranordnung 11,12 hergestellt. Die leitende Verbindung bestehen jeweils in solchen Bereichen, in denen der Klebstoff ausreichend stark zwischen Piezo-Element und Leiteranordnung verdrängt wurde. Da die Leiteranordnung elektrisch getrennte Leitabschnitte 11 und 12 aufweist und das Piezo-Element entsprechend ausgerichtet auf die Leiteranordnung und die Trägerplatte aufgeklebt ist, werden die Kontaktbereiche 3 einerseits und 2 andererseits durch unterschiedliche Leiter 11 bzw. 12 auf der Trägerplatte kontaktiert. Damit ist das Piezo-Element zum Auslesen von Piezo-Spannungen oder Piezo-Ladungen einseitig kontaktiert. Da es sich bei dem Klebstoff 13 um einen elektrisch isolierenden Klebstoff handelt, wird durch diesen zwischen den einzelnen Leiterabschnitten 11, 12 der Leiterstruktur keine elektrisch leitenden Verbindung hergestellt.

Der Aufbau aus Piezo-Element 1 und Träger 10 mit Leiterstruktur 11, 12 ist seitlich in seinen Randbereichen in Halteelementen 15 aufgenommen, so dass er im Bereich des Piezo-Elementes frei getragen wird. Die Halteelemente 15 sind auf einer weiteren Trägerplatte 16 angeordnet, die deutlich dicker und mechanisch stabiler ausgebildet ist als die Trägerplatte 10. Die dickere Trägerplatte 16 begrenzt eine Durchbiegung der Trägerplatte 10 und der darauf befindlichen Anordnung des Piezo-Elements.

Die Leiterstruktur 11 wird in zu dem Piezo-Element versetzten Bereichen in beliebiger üblicher Weise kontaktiert. Erfolgt nun eine Verformung des Piezo-Elements, z. B. durch Druckbelastung, so wir die Piezo-Spannung über die Kontaktbereiche 3 und 2 in die Leiterstruktur 11 eingeleitet und kann dort abgegriffen und ausgewertet werden. Da eine Spannungsinformation oder Ladungsinformation abgefragt wird und lediglich ein vernachlässigbarer Stromfluss stattfindet, ist die Qualität der elektrischen Kontaktierung zwischen den Kontaktflächen 3 und 2 des Piezo-Elements und der Leiterstruktur 11, 12 unkritisch. Die Verbindungen, die beim Aufpressen des Piezo-Elements in den elektrisch isolierenden Klebstoff durch Verdrängen des Klebstoffes hergestellt werden, reichen zur Bereitstellung einer Kontaktierung aus, welche die Abfrage einer entsprechenden Piezo-Spannung erlaubt.

Die Seite des Piezo-Elements, welche eine mechanische Belastung aufnimmt, ist auf diese Weise völlig frei von Kontaktierungsmitteln und demnach ist die erfindungsgemäße Schalteinrichtung sowohl einfach und kostengünstig in der Herstellung (da Lötvorgänge weitgehend wegfallen) als auch robust im Gebrauch, weil das Problem einer auf der Oberseite des Piezo-Elements angebrachten Kontaktierung wegfällt.

Grundsätzlich sind im Rahmen der Erfindung zahlreiche Abwandlungen möglich, welche beispielsweise die Formgebung des Piezo-Elements und die Kontaktierung betreffen. Beispielsweise kann ein leitfähiger Klebstoff verwendet werden, sofern dieser gezielt auf die Kontaktflächen aufgebracht wird und eine unerwünschte Verbindung zwischen Kontaktflächen und Leiterstrukturen verhindert werden kann.

## Patentansprüche

1. Schalteinrichtung für ein Kraftfahrzeug, mit einem Piezo-Element, welches zur einseitigen Kontaktierung ausgebildet ist für den Abgriff einer Piezo-Spannung kontaktiert ist,
dass das Piezo-Element eine erste flächige Seite mit einem ersten Pol und eine zweite, von der ersten Seite abgewandte Seite mit einem zweiten Pol aufweist,
dass das Piezo-Element auf der ersten flächigen Seite des Piezo-Elements wenigstens zwei getrennte Kontaktbereiche aufweist,
wobei ein erster der Kontaktbereiche zur Kontaktierung des ersten Pols des Piezo-Elements ausgebildet ist und ein zweiter der Kontaktbereiche zur Kontaktierung des zweiten Pols des Piezo-Elements ausgebildet ist, wobei der zweite Kontaktbereich von der ersten zur zweiten Seite um das Piezo-Element elektrisch leitend herumgeführt ist,
**dadurch gekennzeichnet,**
**dass** das Piezo-Element mit der ersten Seite auf eine Leiterstruktur aufgeklebt ist, welche auf einem Träger angeordnet ist, wobei als Klebstoff ein elektrisch isolierender Klebstoff eingebracht ist,
wobei die Leiterstruktur mit wenigstens einem ersten Leiter den ersten Kontaktbereich und mit einem vom ersten Leiter getrennten zweiten Leiter den zweiten Kontaktbereich kontaktiert.

2. Schalteinrichtung nach Anspruch 1, **dadurch gekennzeichnet, dass** der Träger und die Leiterstruktur als Leiterplatte mit Leiterbahnen ausgebildet sind.

3. Schalteinrichtung nach einem der Ansprüche 1 bis 2, **dadurch gekennzeichnet, dass** die Leiterplatte eine Dicke<lmm, vorzugsweise <0.4mm aufweist.

4. Schalteinrichtung nach einem der Ansprüche 1 bis 3, **dadurch gekennzeichnet, dass** auf der dem Piezo-Element abgewandten Seite des Trägers eine Halteeinrichtung ausgebildet ist, die den Träger hält und ein Durchbiegen des Trägers bei mechanischer Belastung des Piezo-Elements erlaubt.

5. Schalteinrichtung nach Anspruch 4, **dadurch gekennzeichnet, dass** die Halteeinrichtung einen die maximale Durchbiegung des Trägers begrenzenden Anschlag aufweist.

6. Schalteinrichtung nach einem der Ansprüche 1 bis 5, **dadurch gekennzeichnet, dass** das Piezo-Elements mit einem elektrisch isolierenden Klebstoff unter Druck derart auf die Leiterstruktur und den Träger aufgeklebt ist, dass eine Leitverbindung nur in Bereichen mit unmittelbarem Kontakt zwischen Kontaktflächen und Leiterstruktur besteht.

7. Verfahren zum Herstellen einer Schalteinrichtung für ein Kraftfahrzeug, mit den Schritten:
Vorbereiten eines flächigen Piezo-Elements zur einseitigen Kontaktierung, wobei auf einer ersten flächigen Seite des Piezo-Elements wenigstens zwei getrennte Kontaktbereiche ausgebildet werden,
Vorbereiten einer Leiterplatte, welche den Kontaktbereichen zugeordnete und angepasste Leiterabschnitte aufweist,
Aufkleben des Piezo-Elements auf die Leiterabschnitte und die Leiterplatte, so dass die Kontaktbereiche mit den jeweils zugeordneten Leiterabschnitten in Kontakt gelangen.

8. Verfahren nach Anspruch 7, **dadurch gekennzeichnet, dass** beim Aufkleben ein elektrisch isolierender Kleber verwendet wird und auf das Piezo-Element beim Aufkleben ein solcher Druck ausgeübt wird, dass Abschnitte der Kontaktbereiche mit den Leiterabschnitten unmittelbar in Kontakt kommen.

## Claims

1. A switching device for a motor vehicle with a piezoelectric element, which is constructed for contact on one side and is contacted for picking up a piezoelectric voltage, that the piezoelectric element has a first flat side with a first pole and a second side, directed away from the first side, with a second pole, that the piezoelectric element has at least two separate contact regions on the first flat side of the piezoelectric element, wherein a first of the contact regions is constructed to contact the first pole of the piezoelectric element and a second of the contact regions is constructed to contact the second pole of the piezoelectric element, wherein the second contact region extends electrically conductively around the piezoelectric element from the first to the second side, **characterised in that** the first side of the piezoelectric element is secured by adhesive to a conductive structure which is arranged on a carrier, wherein an electrically insulating adhesive is used as the adhesive, wherein the conductive structure is in contact with at least a first conductor of the first contact region and with a second conductor, separated from the first conductor, of the second contact region.

2. A switching device as claimed in claim 1, **characterised in that** the carrier and the conductive structure are constructed in the form of a printed circuit board with conductive tracks.

3. A switching device as claimed in one of claims 1 to 2, **characterised in that** the printed circuit board has a thickness < 1mm, preferably < 0.44mm.

4. A switching device as claimed in one of claims 1 to 3, **characterised in that** constructed on the side of the support remote from the piezoelectric element is a holding device, which holds the support and permits bending of the carrier when the piezoelectric element is mechanically loaded.

5. A switching device as claimed in claim 4, **characterised in that** the holding device has a stop which limits the maximum bending of the carrier.

6. A switching device as claimed in one of claims 1 to 5, **characterised in that** the piezoelectric element is secured by adhesive to the conductive structure and the carrier with an electrically insulating adhesive under pressure such that a conductive connection exists only in regions with direct contact between the contact surfaces and the conductive structure.

7. A method of manufacturing a switching device for a motor vehicle, with the following steps:
Providing a flat piezoelectric element for contact on one side, wherein formed on a first flat side of the piezoelectric element there are at least two separate contact regions,
Providing a printed circuit board, which has conductive sections associated with and matched to the contact regions,
Securing the piezoelectric element with adhesive to the conductive sections and the printed circuit board so that the contact regions come into contact with the respective associated conductive sections.

8. A method as claimed in claim 7, **characterised in that** electrically insulating adhesive is used for the adhesion and such a pressure is exerted on to the piezoelectric element during the adhesion process that sections of the contact regions come directly into contact with the conductive sections.

## Revendications

1. Dispositif de commutation pour un véhicule automobile, avec un élément piézoélectrique, qui est conformé pour la mise en contact d'une face et est mis en contact pour le prélèvement d'une tension piézoélectrique,
dans lequel l'élément piézoélectrique présente une première face plate avec un premier pôle et une seconde face opposée à la première face avec un second pôle,
l'élément piézoélectrique présente sur la première face plate de l'élément piézoélectrique au moins deux zones de contact séparées,
dans lequel une première des deux zones de contact est conformée pour la mise en contact du premier pôle de l'élément piézoélectrique et une seconde des zones de contact est conformée pour la mise en contact du second pôle de l'élément piézoélectrique, la seconde zone de contact faisant de manière électroconductrice le tour de l'élément piézoélectrique de la première à la seconde face,
**caractérisé en ce que**
l'élément piézoélectrique est collé par la première face sur une structure conductrice, qui est agencée sur un support, sur lequel est déposée comme colle une colle électro-isolante,
dans lequel la structure conductrice est mise en contact par au moins un premier conducteur avec la première zone de contact et par un second conducteur séparé du premier conducteur avec la seconde zone de contact.

2. Dispositif de commutation selon la revendication 1, **caractérisé en ce que** le support et la structure conductrice se présentent sous la forme d'une carte de circuits imprimés ayant des pistes conductrices.

3. Dispositif de commutation selon l'une quelconque des revendications 1 à 2, **caractérisé en ce que** la carte de circuits imprimés présente une épaisseur < 1 mm, de préférence < 0,4 mm.

4. Dispositif de commutation selon l'une quelconque des revendications 1 à 3, **caractérisé en ce que** l'on forme, sur la face du support opposée à l'élément piézoélectrique, un dispositif de maintien qui maintient le support et permet une flexion du support par sollicitation mécanique de l'élément piézoélectrique.

5. Dispositif de commutation selon la revendication 4, **caractérisé en ce que** le dispositif de maintien présente une butée limitant la flexion maximale du support.

6. Dispositif de commutation selon l'une quelconque des revendications 1 à 5, **caractérisé en ce que** l'élément piézoélectrique est collé avec une colle électro-isolante sous pression sur la structure conductrice et le support de sorte qu'une liaison conductrice n'existe que dans les zones avec un contact direct entre les surfaces de contact et la structure conductrice.

7. Procédé de fabrication d'un dispositif de commutation pour un véhicule automobile, ayant les étapes consistant à :
préparer un élément piézoélectrique plat pour la mise en contact d'une face, dans lequel au moins deux zones de contact séparées sont formées sur une première face plate de l'élément piézoélectrique, préparer une carte de circuits imprimés qui présente des sections conductrices affectées et adaptées aux zones de contact, et
coller l'élément piézoélectrique sur les sections conductrices et la carte de circuits imprimés de sorte que les zones de contact soient mises en contact avec les sections conductrices respectivement affectées.

8. Procédé selon la revendication 7, **caractérisé en ce que**, lors du collage, on utilise une colle électro-isolante et on exerce sur l'élément piézoélectrique, lors du collage, une pression telle que des sections des zones de contact viennent en contact directement avec les sections conductrices.
